# FASCICULE DE BREVET EUROPEEN

(11) **EP 2 262 043 B1**
(45) Date de publication et mention de la délivrance du brevet: **20.11.2013**
(21) Numéro de dépôt: 10354026.6
(22) Date de dépôt: 28.05.2010
(51) Int. Cl.: H01M 6/18, H01M 6/40, C23C 14/04, C23C 16/04, C23C 16/46, C23C 14/54, C23C 16/52

(54) **Procédé de réalisation d'au moins un microcomposant avec un masque unique**
Herstellungsverfahren mindestens einer Mikrokomponente mit einer einzigen Maske
Method for manufacturing at least one micro-component with a single mask

(30) Priorité: 09.06.2009 FR 0902785
(43) Date de publication de la demande: 15.12.2010
(73) Titulaire: Commissariat à l'Énergie Atomique et aux Énergies Alternatives, 75015 Paris (FR)
(72) Inventeur: Martin, Steve, 38160 Saint-Sauveur (FR); Dunoyer, Nicolas, 38000 Grenoble (FR); Oukassi, Sami, 38120 Saint-Egrève (FR); Salot, Raphaël, 38250 Lans-en-Vercors (FR)
(74) Mandataire: de Jong, Jean Jacques

(56) Documents cités:
- EP-A1- 1 319 732
- US-A- 5 776 359
- US-A1- 2004 231 595
- US-A1- 2005 034 810

## Description

### Domaine technique de l'invention

L'invention concerne un procédé de réalisation d'au moins un microcomposant, comprenant au moins un empilement de couches sur un substrat, chaque empilement comportant au moins deux couches, une première couche étant déposée suivant un premier motif et une deuxième couche suivant un deuxième motif, différent du premier motif et recouvrant au moins en partie le premier motif.

### État de la technique

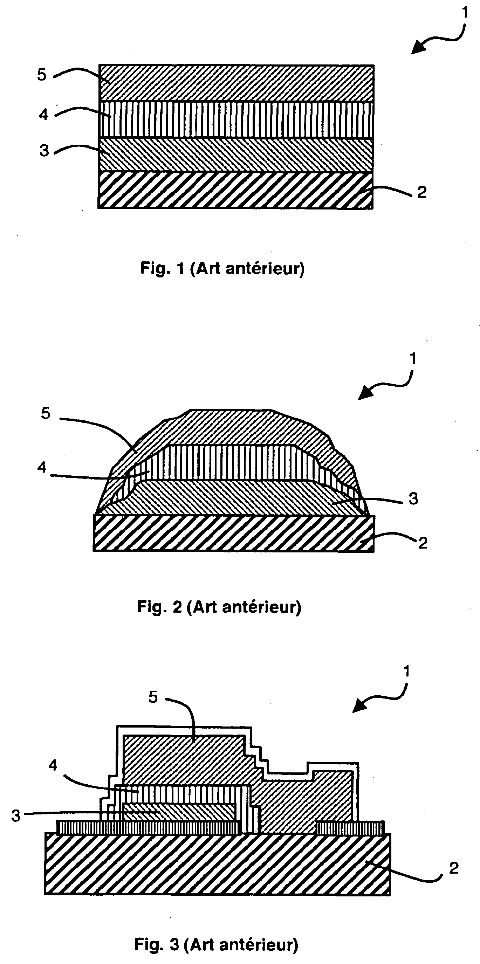

Certains microcomposants sont classiquement réalisés par un empilement successif de couches sur un substrat. Le nombre de couches est supérieur ou égal à 2. La figure 1 représente le cas d'un empilement 1, idéal, sur un substrat 2, sur lequel trois couches (3, 4, 5) sont uniformément déposées. Les techniques utilisées pour réaliser ces empilements 1 sont nombreuses. En particulier, la technique du pochoir est couramment utilisée. Elle consiste à déposer successivement les couches actives (3, 4, 5) du microcomposant par des techniques de dépôt sous vide, PVD par exemple (« Physical Vapor Deposition »), à travers des masques. Ce procédé est avantageux par rapport aux procédés de micro-fabrication traditionnels utilisés en microélectronique, tels que la photolithographie et la gravure. En effet, ce procédé est simple à mettre en oeuvre et peu coûteux. En revanche, l'emploi d'un masque pour le dépôt peut provoquer des inhomogénéités d'épaisseur des couches déposées (3, 4 et 5), dues, entre autres, à l'épaisseur du masque. Ces inhomogénéités d'épaisseur constituent généralement des effets de bord et peuvent mener à la mise en court-circuit du microcomposant, dans le cas de couches conductrices. La figure 2 illustre le cas d'un empilement avec de tels effets de bord. Dans cet exemple, la couche 5 est en contact avec la couche 3 (à gauche de la figure), provoquant un court-circuit si ces deux couches sont conductrices.

Ces microcomposants sont, par exemple, des micro-batteries à couches minces. Une micro-batterie est un composant électrochimique de stockage d'énergie, dont l'épaisseur est généralement inférieure à 15µm. Une micro-batterie comporte au moins un empilement 1 d'au moins trois couches sur un substrat 2, la couche 3, formant une cathode, la couche 4, constituée d'un électrolyte, et la couche 5, formant une anode.

Le brevet US 5,561,004 propose une architecture évitant tout contact entre la couche 3 et la couche 5, pour éviter un court-circuit entre cathode et anode. La figure 3 représente l'architecture d'une micro-batterie selon le brevet US 5,561,004. La couche 4 d'électrolyte est de taille supérieure à la couche 3 de cathode, afin de recouvrir cette dernière entièrement. La couche 4 d'électrolyte étant isolante électriquement, le court-circuit est évité.

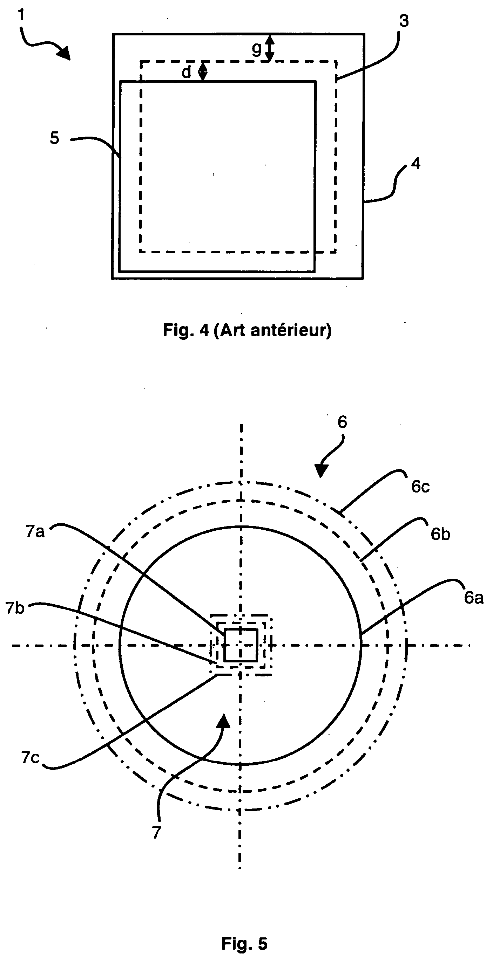

Néanmoins, cette architecture nécessite l'utilisation de plusieurs masques. Du fait des incertitudes de positionnement, liées aux imperfections d'usinage et aux repositionnements successifs des masques, de larges gardes doivent être respectées. Ces gardes, qui correspondent à l'épaisseur latérale de la couche 4 à la périphérie de la couche 3, empêchent tout contact direct entre les couches 3 et 5 constituant les électrodes et peuvent atteindre 100µm de largeur environ. Ces gardes réduisent la surface active du composant, c'est-à-dire la surface d'échange des ions entre les matériaux d'anode et de cathode, et ainsi sa capacité de stockage d'énergie. Une telle structure est représentée en vue de dessus simplifiée (c'est-à-dire sans le substrat 2, ni les collecteurs, ni la couche de protection externe) sur la figure 4. En prenant en compte une garde g de 100µm pour un désalignement d maximum, de 100µm, entre les masques utilisés pour former respectivement la couche 3 de cathode, la couche 4 d'électrolyte et la couche 5 d'anode, la perte de surface active (surface commune aux couches 3 à 5) pour une micro-batterie de 0,25cm² de surface peut atteindre environ 12%.

### Objet de l'invention

L'invention a pour but un procédé de réalisation d'au moins un microcomposant, remédiant aux inconvénients de l'art antérieur. Plus particulièrement, l'invention a pour but un procédé de réalisation, rapide et facile à mettre en oeuvre, permettant de surmonter les problèmes liés au désalignement des masques.

Selon l'invention, ce but est atteint par le fait que le dépôt successif des différentes couches d'un des empilements est réalisé au travers d'une même ouverture d'un même masque, le masque étant porté à une première température (T1), pour former le premier motif, et à une deuxième température (T2), différente de la première température, pour former le deuxième motif.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente schématiquement un empilement de couches idéal.
- la figure 2 représente schématiquement un empilement de couches, selon l'art antérieur.
- la figure 3 représente schématiquement, en coupe, une micro-batterie, selon l'art antérieur.
- La figure 4 illustre, en vue de dessus simplifiée, une partie de l'empilement constituant la micro-batterie de la figure 3.
- la figure 5 représente un mode de réalisation particulier d'un masque utilisable dans le procédé selon l'invention.
- la figure 6 représente un mode de réalisation préférentiel d'un masque utilisable dans le procédé selon l'invention.
- les figures 7 et 8 représentent schématiquement un empilement de couches, obtenu avec un masque de la figure 6, respectivement en vue de dessus et en coupe.
- les figures 9, 10 et 13 représentent, en vue de dessus, d'autres modes de réalisation particuliers d'un masque utilisable dans le procédé selon l'invention.
- les figures 11 et 12 représentent, en coupe selon A-A, deux variantes d'un masque utilisable dans le procédé selon l'invention
- la figure 14 représente une variante de réalisation d'une ouverture du masque de la figure 13.
- la figure 15 représente un mode particulier de réalisation d'un microcomposant, avec un masque selon la figure 14.

### Description de modes particuliers de réalisation

Chaque empilement du microcomposant comporte au moins deux couches. Une première couche est déposée suivant un premier motif et une deuxième couche est ensuite déposée suivant un deuxième motif, différent du premier motif, c'est-à-dire de forme ou taille différente. Le second motif recouvre au moins en partie le premier motif. Pour réaliser un tel microcomposant, un masque est disposé au-dessus du substrat et les dépôts des motifs sont effectués successivement au travers d'une ouverture du masque. Le masque est, de préférence, en acier pour un substrat en silicium. Il peut aussi être par exemple en molybdène, en aluminium, en cuivre, en Invar® (alliage Fe-Ni 36% de la société Imphy Alloys) selon le substrat utilisé.

Dans le mode de réalisation de la figure 5, le masque 6 se dilate ou se rétracte, respectivement, si sa température augmente ou diminue. Le masque 6 comporte une ouverture 7 centrale. Le masque 6, initialement porté à une température T1, est représenté en trait plein (6a), avec l'ouverture 7 correspondante, également en trait plein (7a). Lorsqu'il est chauffé à une température T2, supérieure à T1, le masque 6 se dilate (tirets 6b), de même que l'ouverture 7 (tirets 7b). De manière analogue, à une température T3, supérieure à T2, le masque 6 et l'ouverture 7 s'agrandissent encore (traits mixtes 6c et 7c). Ainsi, les références 6a, 6b et 6c représentent le même masque 6 à des températures différentes. De même, les références 7a, 7b et 7c représentent la même ouverture 7 à ces différentes températures.

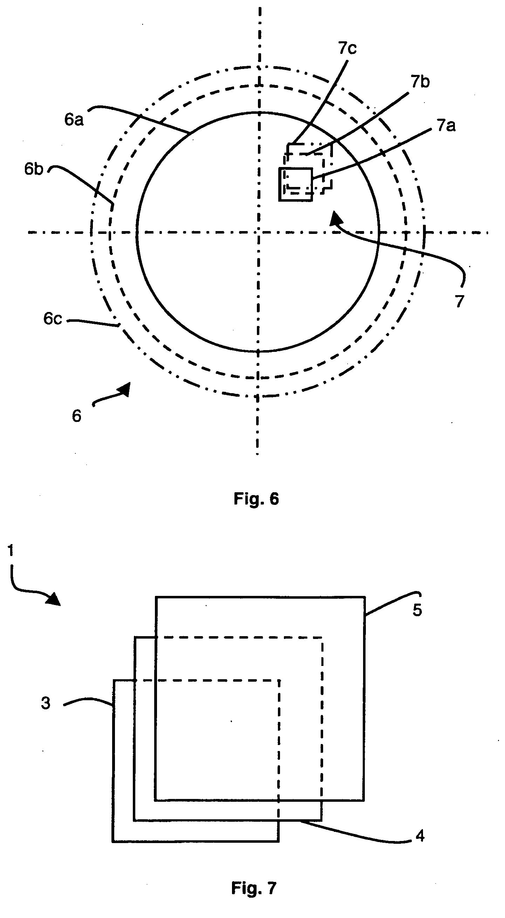

Dans le mode de réalisation préférentiel de la figure 6, le masque 6a, à la température T1, comporte une ouverture 7a excentrée. Comme précédemment, le masque se dilate ou se rétracte en fonction des variations de température (6b et 7b à la température T2>T1, et 6c et 7c à la température T3>T2).

L'ouverture 7 dans le masque 6 est utilisée pour déposer successivement les différentes couches d'un empilement. En effet, en modifiant la température du masque 6, la taille de l'ouverture 7 varie. Le masque est ainsi porté à la première température (T1), pour déposer la première couche et former le premier motif, et à la deuxième température (T2), différente de la première température, pour déposer la deuxième couche et ainsi former le deuxième motif.

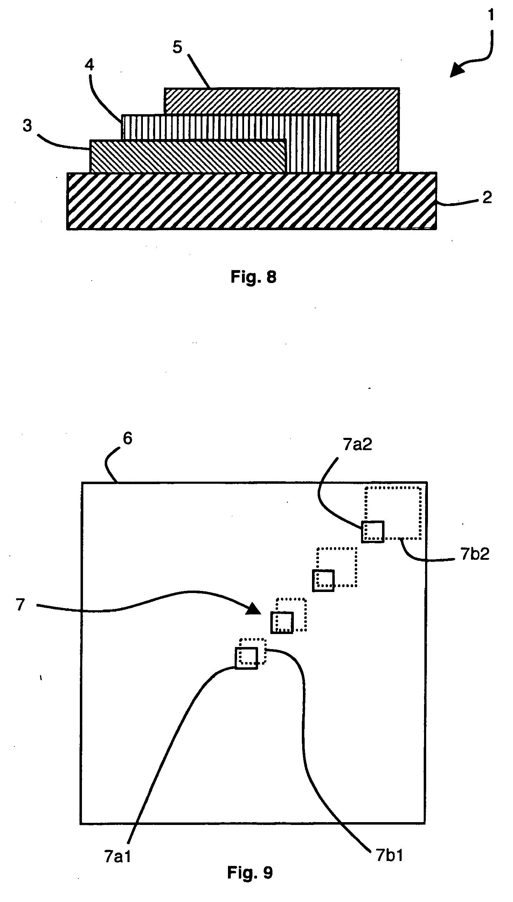

Dans le mode de réalisation des figures 7 et 8, les dépôts des couches 3, 4 et 5, de motifs différents, sont réalisés successivement au travers de la même ouverture 7 du même masque 6, en utilisant, de préférence, le masque de la figure 6. Ainsi, le masque 6 étant à la température T1, la couche 3 est déposée au travers de l'ouverture 7a du masque 6a. Ensuite, le masque 6 étant à la température T2, supérieure à T1, la couche 4 est déposée au travers de l'ouverture 7b du masque 6b. Enfin, le masque 6 étant à la température T3, supérieure à T2, la couche 5 est déposée au travers de l'ouverture 7c du masque 6c. La figure 8 montre un décalage entre les motifs de l'empilement 1, l'un par rapport l'autre, parallèlement au substrat 2. En effet, comme illustré à la figure 7, en se dilatant, l'ouverture excentrée se décale.

Le procédé décrit ci-dessus n'utilise qu'un seul masque pour les dépôts successifs. Aucune manipulation de masque n'est donc nécessaire, évitant ainsi les problèmes liés au désalignement des masques. De plus, le contrôle de la géométrie des motifs par la dilation thermique du masque permet d'obtenir un décalage entre deux motifs superposés de l'ordre de 10µm alors que l'art antérieur montre un décalage jusqu'à 100µm. Le procédé décrit ci-dessus permet plus particulièrement de réduire la perte de surface active du microcomposant. Comme décrit ci-dessus, si la température du masque est modifiée de manière à varier toujours dans le même sens (croissant ou décroissant) lors du passage du dépôt d'une couche à la couche suivante, tout contact direct des couches 3 et 5 est évité. Dans le cas d'une micro-batterie, un court-circuit entre les couches 3 et 5 des électrodes est alors évité. Par exemple, pour une micro-batterie de 25mm² de surface, située à une distance de 5cm du bord du substrat en silicium, la dilatation d'un masque en acier est de 10µm par rapport au substrat en silicium pour une variation de température de 20°C. La perte de surface active d'une batterie, réalisée avec trois couches formées à des températures augmentant par paliers de 20°C, est de l'ordre de 0,4% contre 12% pour une micro-batterie réalisée selon l'art antérieur. Le procédé utilisé permet ainsi à la fois de maximiser la surface active de la micro-batterie et d'éviter toute mise en court-circuit de l'anode et de la cathode.

Le masque 6 comporte, de préférence, une pluralité d'ouvertures 7 disposées de manière régulière et ordonnée (Figs. 9, 10 et 13), de manière à réaliser simultanément plusieurs empilements 1, augmentant ainsi la rentabilité du procédé. Chaque ouverture 7 est associée à un empilement 1 différent. Cependant, le contrôle de la dilation d'un masque 6, de dimensions importantes, et comportant un nombre important d'ouvertures 7, est difficile. En effet, la dilation du masque 6 varie en fonction de l'éloignement par rapport à son centre. Ceci est représenté sur la figure 9, dans le cas d'une portion de masque 6 avec quatre ouvertures 7. Pour une même augmentation de température, une ouverture 7 proche du centre (7a1, 7b1) du masque 6 se dilate moins qu'une ouverture 7 à son extrémité (7a2, 7b2). De plus, dans ce mode de réalisation, afin d'éviter le recouvrement de différentes couches de plusieurs empilements, le dimensionnement de chaque ouverture 7 doit, de préférence, tenir compte des dimensions maximales de l'ouverture 7 après dilatation, appelées également cotes maximales de dilatation.

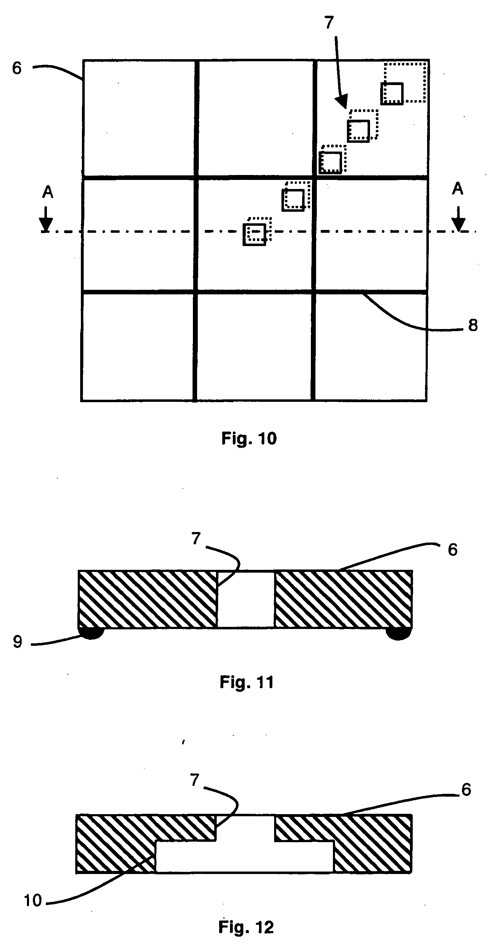

Pour des masques de grandes dimensions, la cote maximale de dilatation des ouvertures 7 peut atteindre 100µm, réduisant la surface active du microcomposant. De plus, la densité d'intégration sur le masque 6, et donc sur le substrat, reste faible dans ce cas. De manière à réduire la cote maximale de dilatation, le masque 6 est avantageusement subdivisé en au moins deux parties élémentaires séparées par des joints de dilatation 8. Sur la figure 10, le masque 6 est, par exemple, divisé en neuf sous-parties par quatre joints 8. Ces joints de dilatation sont réalisés, par exemple, en matériau polymère, tel que le caoutchouc, le polyuréthane ou le polypropylène.

Dans les modes de réalisation précédents, le masque est généralement plaqué sur le substrat par son propre poids. Lorsque le masque se déforme sous l'action de la température, il peut endommager les couches précédemment déposées, par exemple en les rayant. Pour remédier à ce problème, le masque 6 comporte avantageusement, à sa partie inférieure, des cales 9 afin de surélever le masque 6 par rapport au substrat (Fig. 11). Le masque 6 peut également comporter un évidement 10 autour de chaque ouverture 7, sur sa face inférieure, du côté du substrat (Fig. 12). Dans une variante, l'évidement peut être commun à l'ensemble des ouvertures, formant une cale continue en périphérie de masque.

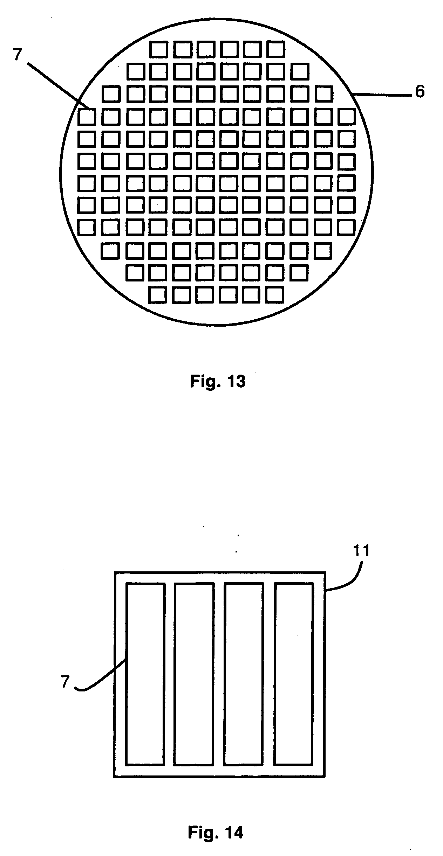

Dans le mode de réalisation préférentiel décrit ci-dessus, le masque comporte une pluralité d'ouvertures excentrées. Dans l'exemple de la figure 13, le masque 6 comporte cent vingt ouvertures 7. Chaque ouverture 7 a la forme d'un parallélogramme, en général, un carré. Il existe également d'autres formes d'ouverture selon la géométrie du motif à réaliser. Chaque ouverture permet la formation d'un empilement distinct. La distance entre deux ouvertures 7 adjacentes du masque 6 et les différentes températures peuvent être choisies pour former des microcomposants distincts, de type micro-batterie par exemple, comprenant chacun un seul empilement de motifs. En effet, la différence entre la température du masque, utilisée pour former simultanément les premières couches des différents empilements, et la température du masque, utilisée pour former simultanément les dernières couches des différents empilements, fixe le décalage maximum entre le premier et le dernier motif. Si ce décalage est inférieur à la distance entre des ouvertures adjacentes, des empilements indépendants sont obtenus.

A titre d'exemple, le masque de la figure 13 peut être utilisé pour fabriquer des micro-batteries constituées chacune par un empilement, sur une plaque de silicium de 200mm de diamètre et 500µm d'épaisseur environ. Le substrat est recouvert d'une couche de nitrure de silicium d'environ 100nm d'épaisseur, par dépôt chimique en phase vapeur. Un masque, en acier, de 200mm de diamètre et d'une épaisseur de 300µm environ, est plaqué par son propre poids sur ce substrat. Des ouvertures carrées de 10mm de côté sont réalisées dans ce masque. Elles sont espacées, l'une par rapport aux autres, de 2,5mm environ. Un évidement, de 0,15mm de profondeur et 0,15mm de largeur, est réalisé en périphérie de chaque ouverture afin d'éviter les phénomènes de rayure des couches lors de la dilatation. La cote de dilatation maximale est calculée à partir de l'emplacement des batteries les plus éloignées du centre de la plaque. Cette cote est estimée à 0,75µm/C°

L'ensemble est introduit dans une machine de dépôt sous vide industrielle de type Endura® de la société Applied Material. Dans ce type d'appareil, cinq chambres de dépôt permettent de former successivement les différentes couches actives de la batterie dans le même équipement, sans opération manuelle. Ainsi, une première couche de tungstène (collecteur cathodique), d'environ 300nm d'épaisseur, est déposée, le substrat et le masque étant tous deux maintenus à une température de 40°C grâce à un porte-substrat contrôlé en température. L'ensemble substrat/masque est alors chargé dans une seconde chambre et chauffé à une température de 60°C, et un dépôt d'oxysulfure de titane (TiOS) (cathode) de 1,5µm d'épaisseur environ est réalisé. Puis, l'ensemble est chargé dans une troisième chambre et chauffé à une température de 80°C. Un dépôt de LiPON (électrolyte) de 1µm d'épaisseur environ est alors réalisé. L'ensemble est chargé dans une quatrième chambre et chauffé à une température de 100°C. Un dépôt de lithium (anode) de 1µm d'épaisseur environ est alors réalisé. Enfin, l'ensemble substrat/masque est chargé dans une cinquième et dernière chambre et chauffé à une température de 120°C. Un dépôt de titane (collecteur anodique) de 250nm d'épaisseur environ est alors réalisé.

Le gradient total de température lors de ces étapes de dépôt est de 80°C. La cote de dilatation maximale est donc de 60µm. Les ouvertures adjacentes étant séparées de 2,5mm, il n'y a pas de chevauchement d'un empilement à l'autre à cause du décalage entre les première et dernière couches. La perte de surface active maximale est de 1,6%.

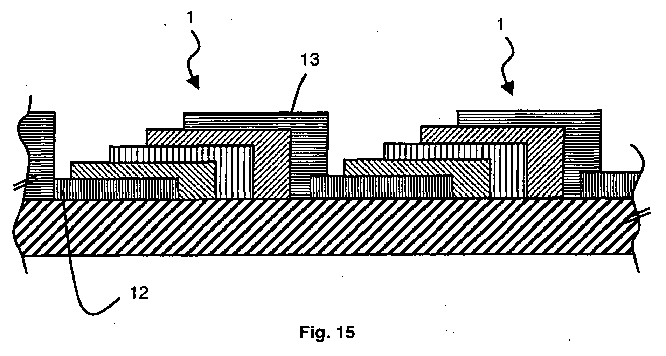

Dans une variante de réalisation, des microcomposants, comprenant chacun plusieurs empilements 1, peuvent être réalisés. Les ouvertures 7, associées aux empilements 1 d'un même microcomposant, constituent alors un groupe 11 d'ouvertures, comme celui représenté sur la figure 14. Dans ce cas, le choix de la distance entre deux ouvertures adjacentes d'un même groupe 11 et des différentes températures permet de connecter en série deux empilements adjacents d'un même microcomposant. Ce mode particulier de réalisation est illustré sur la figure 15. En effet, en choisissant la distance entre deux ouvertures, inférieure au décalage maximum entre le premier motif 12 et le dernier motif 13, fixé par le gradient total de température, la dernière couche d'un empilement 1 recouvre la première couche de l'empilement 1 adjacent. Cette configuration est particulièrement intéressante dans le cas des micro-batteries.

Enfin, la distance entre deux groupes 11 d'ouvertures 7 est choisie suffisamment grande pour former des microcomposants séparés, chacun comportant plusieurs empilements 1 connectés en série.

A titre d'exemple, le groupe 11 d'ouvertures de la figure 14 est reproduit de façon périodique sur le masque. La distance entre deux ouvertures, au sein d'un même groupe 11, est de l'ordre de 80µm. Les autres paramètres du masque sont inchangés par rapport à l'exemple précédent. Le substrat est également identique. L'épaisseur et la nature des cinq couches restent inchangées. Seules les températures de dépôt changent.

Le dépôt de tungstène s'effectue à une température du masque de 40°C. Le dépôt de TiOS s'effectue à une température du masque de 70°C. Le dépôt de LiPON s'effectue à une température du masque de 100°C. Le dépôt de lithium s'effectue à une température du masque de 130°C. Le dépôt de titane s'effectue à une température du masque de 160°C.

Le gradient total de température lors de ces étapes de dépôt est de 120°C. La cote de dilatation maximale est donc de 90µm. Deux groupes d'ouvertures adjacents étant séparés de 2,5mm, il n'y a pas de chevauchement d'un microcomposant à l'autre. Cependant, à l'intérieur d'un groupe d'ouvertures, les décalages successifs d'une ouverture en fonction du gradient de température (au total : 90µm) provoquent un chevauchement des couches de collecteur anodique et cathodique de deux empilements adjacents, correspondant à deux ouvertures adjacentes au sein du groupe. Ces empilements sont alors mis en série.

## Revendications

1. Procédé de réalisation d'un microcomposant comprenant un empilement (1) sur un substrat (2), l'empilement comportant une première couche déposée suivant un premier motif et une deuxième couche déposée suivant un deuxième motif, différent du premier motif, **caractérisé en ce que** le premier motif est formé au travers d'une ouverture (7) d'un masque (6) porté à une première température (T1), et **en ce que** le deuxième motif est formé au travers de la même ouverture du même masque porté à une deuxième température (T2), différente de la première température.

2. Procédé selon la revendication 1, **caractérisé en ce que** le masque (6) est en acier.

3. Procédé selon l'une des revendications 1 et 2, **caractérisé en ce que** l'ouverture (7) du masque (6) est excentrée, pour décaler les premier et deuxième motifs, l'un par rapport à l'autre, parallèlement au substrat (2).

4. Procédé selon l'une quelconque des revendications 1 à 3, **caractérisé en ce que** chaque ouverture (7) a la forme d'un parallélogramme.

5. Procédé selon l'une quelconque des revendications 1 à 4, **caractérisé en ce que** le masque (6) comporte une pluralité d'ouvertures (7), associées chacune à un empilement (1) différent, disposées de manière régulière et ordonnée, les différents empilements étant fabriqués simultanément.

6. Procédé selon la revendication 5, **caractérisé en ce que** la distance entre deux ouvertures (7) adjacentes et la différence entre la température du masque (6), utilisée pour former simultanément les premières couches des différents empilements (1), et la température du masque, utilisée pour former simultanément une dernière couche de chaque empilement, sont choisies pour former des empilements indépendants espacés l'un de l'autre, appartenant à des microcomposants distincts.

7. Procédé selon la revendication 5, **caractérisé en ce que** la distance entre deux ouvertures (7) adjacentes et la différence entre la température du masque (6), utilisée pour former simultanément les premières couches des différents empilements (1), et la température du masque (6), utilisée pour former simultanément une dernière couche de chaque empilement, sont choisies pour provoquer le recouvrement de la dernière couche d'un empilement avec la première couche d'un empilement adjacent, de manière à connecter en série deux empilements adjacents d'un même microcomposant.

8. Procédé selon la revendication 7, **caractérisé en ce que** les ouvertures (7) du masque (6), associées aux empilements (1) d'un même microcomposant, constituent un groupe (11) d'ouvertures, et **en ce que** la distance entre deux groupes d'ouvertures adjacents est choisie pour former deux microcomposants espacés l'un de l'autre.

9. Procédé selon l'une quelconque des revendications 1 à 8, **caractérisé en ce que** le microcomposant est une micro-batterie.

10. Procédé selon l'une quelconque des revendications 1 à 9, **caractérisé en ce que** le masque (6) est subdivisé en au moins deux parties élémentaires séparées par des joints de dilatation (8).

11. Procédé selon l'une quelconque des revendications 1 à 10, **caractérisé en ce que** le masque (6) comporte un évidement (10) sur une face inférieure, du côté du substrat (2), autour de chaque ouverture (7).

12. Procédé selon l'une quelconque des revendications 1 à 10, **caractérisé en ce que** le masque (6) est surélevé par rapport au substrat (2) par des cales (9).

## Patentansprüche

1. Verfahren zur Herstellung einer Mikrokomponente, die einen Stapel (1) auf einem Substrat (2) umfasst, wobei der Stapel eine entsprechend einem ersten Muster abgeschiedene erste Schicht und eine entsprechend einem von dem ersten Muster abweichenden zweiten Muster abgeschiedene zweite Schicht umfasst, **dadurch gekennzeichnet, dass** das erste Muster durch eine Öffnung (7) einer Maske (6), die auf eine erste Temperatur (T1) erhitzt ist, gebildet wird und dass das zweite Muster durch die gleiche Öffnung der gleichen Maske, die auf eine von der ersten Temperatur abweichende zweite Temperatur (T2) erhitzt ist, gebildet wird.

2. Verfahren nach Anspruch 1, **dadurch gekennzeichnet, dass** die Maske (6) aus Stahl besteht.

3. Verfahren nach einem der Ansprüche 1 und 2, **dadurch gekennzeichnet, dass** die Öffnung (7) der Maske (6) außermittig angeordnet ist, um das erste und das zweite Muster parallel zu dem Substrat (2) zueinander zu versetzen.

4. Verfahren nach einem der Ansprüche 1 bis 3, **dadurch gekennzeichnet, dass** jede Öffnung (7) die Form eines Parallelogramms aufweist.

5. Verfahren nach einem der Ansprüche 1 bis 4, **dadurch gekennzeichnet, dass** die Maske (6) eine Vielzahl von jeweils einem anderen Stapel (1) zugeordneten Öffnungen (7) umfasst, die gleichmäßig und geordnet angeordnet sind, wobei die unterschiedlichen Stapel gleichzeitig hergestellt werden.

6. Verfahren nach Anspruch 5, **dadurch gekennzeichnet, dass** der Abstand zwischen zwei benachbarten Öffnungen (7) und der Unterschied zwischen der Temperatur der Maske (6), die für das gleichzeitige Ausbilden der ersten Schichten der unterschiedlichen Stapel (1) angewandt wird, und der Temperatur der Maske, die für das gleichzeitige Ausbilden einer letzten Schicht eines jeden Stapels angewandt wird, gewählt sind, um voneinander beabstandete, unabhängige Stapel, die zu verschiedenen Mikrokomponenten gehören, auszubilden.

7. Verfahren nach Anspruch 5, **dadurch gekennzeichnet, dass** der Abstand zwischen zwei benachbarten Öffnungen (7) und der Unterschied zwischen der Temperatur der Maske (6), die für das gleichzeitige Ausbilden der ersten Schichten der unterschiedlichen Stapel (I) angewandt wird, und der Temperatur der Maske (6), die für das gleichzeitige Ausbilden einer letzten Schicht eines jeden Stapels angewandt wird, gewählt sind, um das Bedecken der letzten Schicht eines Stapels mit der ersten Schicht eines benachbarten Stapels zu bewirken, um zwei benachbarte Stapel einer gleichen Mikrokomponente in Reihe zu schalten.

8. Verfahren nach Anspruch 7, **dadurch gekennzeichnet, dass** die Öffnungen (7) der Maske (6), die den Stapeln (1) einer gleichen Mikrokomponente zugeordnet sind, eine Gruppe (11) von Öffnungen bilden und dass der Abstand zwischen zwei benachbarten Gruppen von Öffnungen gewählt ist, um zwei voneinander beabstandete Mikrokomponenten zu bilden.

9. Verfahren nach einem der Ansprüche 1 bis 8, **dadurch gekennzeichnet, dass** die Mikrokomponente eine Mikrobatterie ist.

10. Verfahren nach einem der Ansprüche 1 bis 9, **dadurch gekennzeichnet, dass** die Maske (6) in wenigstens zwei Einzelteile unterteilt ist, die durch Dehnungsfugen (8) getrennt sind.

11. Verfahren nach einem der Ansprüche 1 bis 10, **dadurch gekennzeichnet, dass** die Maske (6) eine Aussparung (10) auf einer Unterseite, auf der Seite des Substrats (2), um jede Öffnung (7) herum umfasst.

12. Verfahren nach einem der Ansprüche 1 bis 10, **dadurch gekennzeichnet, dass** die Maske (6) gegenüber dem Substrat (2) durch Keile (9) erhöht ist.

## Claims

1. Method for producing a microcomponent comprising a stack (1) on a substrate (2), the stack comprising a first layer deposited with a first pattern and a second layer with a second pattern, different from the first pattern, **characterized in that** the first pattern is performed through a opening (7) of a mask (6) heated to a fist temperature (T1), and **in that** the second pattern is performed through the same opening of the same mask heated to a second temperature (T2), different from the first temperature.

2. Method according to claim 1, **characterized in that** the mask (6) is made of steel.

3. Method according to one of the claims 1 and 2, **characterized in that** the opening (7) of the mask (6) is off-centered to offset the first and second patterns with respect to one another, in a direction parallel to the substrate (2).

4. Method according to any one of the claims 1 to 3, **characterized in that** each opening (7) is in the shape of a parallelogram.

5. Method according to any one of the claims 1 to 4, **characterized in that** the mask (6) comprises a plurality of openings (7), each associated with a different stack (1), arranged in regular and ordered manner, the different stacks being fabricated simultaneously.

6. Method according to claim 5, **characterized in that** the distance between two adjacent openings (7) and the difference between the temperature of the mask (6) used to simultaneously form the first layers of the different stacks (1), and the temperature of the mask used to simultaneously form the last layer of each stack, are chosen to form independent stacks spaced apart from one another, belonging to distinct microcomponents.

7. Method according to claim 5, **characterized in that** the distance between two adjacent openings (7) and the difference between the temperature of the mask (6) used to simultaneously form the first layers of the different stacks (1), and the temperature of the mask (6) used to simultaneously form the last layer of each stack, are chosen such as to make the last layer of a stack overlap with the first layer of an adjacent stack so as to connect two adjacent stacks of the same microcomponent in series.

8. Method according to claim 7, **characterized in that** the openings (7) of the mask (6), associated with the stacks (1) of the same microcomponent, form a group (11) of openings, and **in that** the distance between two groups of adjacent openings is chosen such as to form two microcomponents spaced apart from one another.

9. Method according to any one of the claims 1 to 8, **characterized in that** the microcomponent is a microbattery.

10. Method according to any one of the claims 1 to 9, **characterized in that** the mask (6) is subdivided into at least two elemental parts separated by expansion joints (8).

11. Method according to any one of the claims 1 to 10, **characterized in that** the mask (6) comprises a recess (10) around each opening (7) on a bottom surface, on the substrate (2) side.

12. Method according to any one of the claims 1 to 10, **characterized in that** the mask (6) is raised with respect to the substrate (2) by shims (9).
